(19) **Europäisches Patentamt / European Patent Office / Office européen des brevets**

(11) **EP 4 700 831 A2**

(12) # EUROPEAN PATENT APPLICATION

(43) Date of publication:
**25.02.2026 Bulletin 2026/09**

(21) Application number: **25178094.6**

(22) Date of filing: **22.05.2025**

(51) International Patent Classification (IPC):
**H01L 23/66** (2006.01)    **H01L 23/552** (2006.01)
**H01L 21/60** (2006.01)    **H01L 23/04** (2006.01)
**H01L 23/367** (2006.01)

(52) Cooperative Patent Classification (CPC):
**H10W 44/20; H10W 40/22; H10W 42/20;**
**H10W 76/12; H10W 90/00;** H10W 42/121;
H10W 44/248; H10W 44/255; H10W 72/072;
H10W 72/073; H10W 72/20; H10W 72/30;
H10W 72/851; H10W 99/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **19.08.2024  US 202463684603 P
10.02.2025  TW 114104780**

(71) Applicant: **Industrial Technology Research
Institute
310401 Hsinchu (TW)**

(72) Inventors:
• **Kao, Hao Che
310 Hsinchu County (TW)**
• **Lin, Yu-Min
310 Hsinchu County (TW)**
• **Liu, Wen-Hung
403 Taichung City (TW)**
• **Lee, Ching-Kuan
655 Yunlin County (TW)**

(74) Representative: **Fuchs Patentanwälte
Partnerschaft mbB
Tower 185
Friedrich-Ebert-Anlage 35-37
60327 Frankfurt am Main (DE)**

(54) **FLIP-CHIP BONDING-BASED ANTENNA PACKAGING STRUCTURE AND ITS MANUFACTURING METHOD**

(57)    A flip-chip bonding-based antenna packaging structure and its manufacturing method are provided. The flip-chip bonding-based antenna packaging structure includes a lead frame structure (LFS) and a redistribution structure (RDS) disposed above the lead frame structure. The redistribution structure includes a first surface (11A) and a second surface (11B). The lead frame structure is disposed on the redistribution structure and includes a metal member (14), a first active element (131), and a passive element (16). The metal member includes a base portion (140), a first supporting portion (142) on the base portion, and an extension portion (141) adjacent to the first supporting portion. The extension portion extends from the base portion, and the first supporting portion is parallel to the extension portion. The first active element is disposed between the first supporting portion and the first surface. The passive element is disposed on the second surface and is electrically connected to the first active element.

FIG. 9A

**Description**

**CROSS REFERENCE TO RELATED APPLICATIONS**

This application claims the benefit of U.S. Provisional Application No. 63/684,603, filed on August 19, 2024, and priority of Taiwan Patent Application No. 114104780, filed on February 10, 2025, the entirety of which are incorporated by reference herein.

**TECHNICAL FIELD**

The present disclosure relates to an antenna packaging structure, and relates to a flip-chip bonding-based antenna packaging structure and its manufacturing method.

**BACKGROUND**

Traditional radio frequency (RF) chips are typically bonded to a ceramic substrate in a face-up configuration, with wire bonding used for signal transmission. While wire bonding can improve the heat dissipation performance of traditional RF chips to some extent, the relatively long signal transmission path is susceptible to significant parasitic effects, thereby affecting transmission efficiency and signal stability. Specifically, parasitic inductance suppresses the high-frequency components of the signal, leading to a reduced frequency response and distortion of high-frequency signals. Parasitic capacitance causes leakage current under high-frequency operation. Furthermore, if there is an impedance mismatch, signal reflection may occur, resulting in standing wave phenomena, which can negatively impact overall transmission performance.

With the rise of low-orbit satellites and millimeter-wave applications, the adoption of Chiplet and Heterogeneous Integration in antenna-in-packaging (AiP) has gradually become a key approach to addressing the challenges of high-frequency RF systems (such as those operating in the millimeter-wave and terahertz wave bands). However, there are still technical issues to be resolved in millimeter-wave frequency bands and high-power RF systems. The first issue is that traditional wire bonding fails to provide sufficiently low transmission latency and path loss. When RF signals travel along relatively long transmission paths in the millimeter-wave frequency band, significant signal loss and reflection occur. Secondly, multiple chips with different functions (such as processors, RF modules, memory, etc.) are integrated into a compact package structure ranging from several millimeters to tens of millimeters in size. While this miniaturization helps reduce the overall system volume and decreases signal transmission latency, it also exacerbates electromagnetic interference (EMI). Due to the extremely small spaces between multiple chips, electromagnetic coupling and signal crosstalk occurs across chips. Additionally, when high-power components (such as power amplifiers) coexist with the RF components, the strong currents and high-frequency noise generated by the power amplifier during operation can interfere with nearby RF modules. This interference can lead to RF signal distortion, insufficient high-frequency noise suppression, or an unstable system frequency response.

**SUMMARY**

In some embodiments, a flip-chip bonding-based antenna packaging structure is provided. The flip-chip bonding-based antenna packaging structure includes a lead frame structure and a redistribution structure disposed on the lead frame structure. The redistribution structure includes a first surface and a second surface opposite to each other. The lead frame structure is disposed on the redistribution structure and includes a metal member, a first active element, and a passive element. The metal member includes a base portion, a first supporting portion, and an extension portion. The first supporting portion extends along a vertical direction on the base portion. The extension portion is adjacent to the first supporting portion. The extension portion extends from the base portion to be attached to the first surface, and the first supporting portion is parallel to the extension portion. The first active element is disposed between the first supporting portion and the first surface and is attached to the first surface. The passive element is disposed on the second surface. The passive element is electrically connected to the first active element.

In some embodiments, a manufacturing method for a flip-chip bonding-based antenna packaging structure is provided. The manufacturing method for the flip-chip bonding-based antenna packaging structure includes the following steps. A redistribution structure is provided on a carrier, wherein the redistribution structure has a first surface and a second surface opposite to each other. A first active element is disposed on the first surface. A metal member is disposed on the first active element, wherein the metal member includes a base portion, a first supporting portion extending along a vertical direction on the base portion, and an extension portion adjacent to the first supporting portion. The extension portion extends from the base portion to be attached to the first surface, the first supporting portion is parallel to the extension portion, and the first active element is disposed between the first surface and the first supporting portion. The carrier is removed to expose the second surface. A passive element is disposed on the second surface to be electrically connected to the first active element.

The flip-chip bonding-based antenna packaging structure of the present disclosure may be applied to a variety of electronic products. In order to make the features and advantages of the present disclosure more comprehensible, various embodiments are specially cited hereinafter, together with the accompanying drawings, to be described in detail as follows.

## BRIEF DESCRIPTION OF THE DRAWINGS

Aspects of the present disclosure are best understood from the following detailed description when read with the accompanying figures. It should be noted that, in accordance with the standard practice in the industry, various features are not drawn to scale. In fact, the dimensions of the various features may be arbitrarily increased or reduced for clarity of discussion.

FIG. 1 to FIG. 6 are schematic cross-sectional views illustrating different stages of the manufacturing process for the flip-chip bonding-based antenna packaging structure in accordance with some embodiments of the present disclosure.

FIG. 7 and FIG. 8 are schematic cross-sectional views illustrating different stages of the manufacturing process for the flip-chip bonding-based antenna packaging structure in accordance with other embodiments of the present disclosure.

FIG. 9A is a schematic cross-sectional view illustrating the flip-chip bonding-based antenna packaging structure in accordance with some embodiments of the present disclosure.

FIG. 9B is a schematic cross-sectional view illustrating the flip-chip bonding-based antenna packaging structure in accordance with other embodiments of the present disclosure.

FIG. 9C is a schematic cross-sectional view illustrating the flip-chip bonding-based antenna packaging structure in accordance with yet other embodiments of the present disclosure.

FIG. 9D is a schematic top view illustrating the flip-chip bonding-based antenna packaging structure in accordance with some embodiments of the present disclosure.

FIG. 10 to FIG. 14 are schematic cross-sectional diagrams illustrating different aspects of the flip-chip bonding-based antenna packaging structure in accordance with some embodiments of the present disclosure.

FIG. 15 to FIG. 18 are schematic cross-sectional diagrams illustrating different aspects of the flip-chip bonding-based antenna packaging structure in accordance with some embodiments of the present disclosure.

## DETAILED DESCRIPTION

The following disclosure provides many different embodiments or examples for implementing the provided device. Specific examples of features and their configurations are described below to simplify the embodiments of the present disclosure, but certainly not to limit the present disclosure. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

In some embodiments of the present disclosure, terms related to disposing and connection, such as "dispose", "connect", and the like, unless otherwise defined, may refer to two components in direct contact, or may also refer to two components not in direct contact, that is there is another component disposed between the two components. Moreover, the terms related to disposing and connection can also include embodiments in which both structures are movable, or both structures are fixed.

Furthermore, the terms "first," "second," and similar expressions mentioned in this specification or the claims are used to name different components or to distinguish different embodiments or scopes. They are not intended to impose any upper or lower limits on the number of components, nor are they intended to specify the manufacturing sequence or arrangement order of the components.

Herein, the terms "approximately", "about", and "substantially" generally mean within 10%, within 5%, within 3%, within 2%, within 1%, or within 0.5% of a given value or range. The given value is an approximate value, that is, "approximately", "about", and "substantially" can still be implied without the specific description of "approximately", "about", and "substantially". The phrase "a range between a first value and a second value" means that the range includes the first value, the second value, and other values in between. Furthermore, any two values or directions used for comparison may have certain tolerance. If the first value is equal to the second value, it implies that there may be a tolerance within about 10%, within 5%, within 3%, within 2%, within 1%, or within 0.5% between the first value and the second value. If the first direction is perpendicular to the second direction, the angle between the first direction and the second direction may be between 80 degrees and 100 degrees. If the first direction is parallel to the second direction, the angle between the first direction and the second direction may be between 0 degrees and 10 degrees.

It should be understood that, for clarity of illustration, some elements of the device are omitted in the drawings, and only certain components are illustrated. In some embodiments, additional components may be added to the device described below. In other embodiments, certain components of the device described below may be replaced or omitted. It should also be understood that, in some embodiments, additional operational steps may be provided before, during, and/or after the manufacturing process of the device. In some embodiments, certain operational steps may be replaced or omitted, and the sequence of certain operational steps may be interchangeable.

Unless otherwise defined, all terms (including technical and scientific terms) used herein have the same meaning as commonly understood by a person of ordinary skills in the art. It is understood that these terms, such as those defined in commonly used dictionaries, should be interpreted as having meanings consistent with the relevant art and the background or context of the present disclosure, and should not be interpreted in an idealized or overly formal manner, unless otherwise defined in the embodiments of the present disclosure.

In some existing antenna packaging structures, a ceramic packaging method may be used to integrate a radio frequency (RF) chip and an antenna. Specifically, the RF chip is placed on a ceramic substrate, and it is electrically connected to the antenna through wire bonding. However, this approach is not suitable for multi-chip heterogeneous integration and suffers from significant signal loss issues. Furthermore, flip-chip packaging results in poor heat dissipation efficiency and also faces challenges related to insufficient line width and line spacing, making it unsuitable for high-frequency applications. Similarly, fan-out packaging also exhibits poor heat dissipation efficiency, and its complex fabrication process leads to high manufacturing costs. To address these issues, the present disclosure provides a flip-chip bonding-based antenna packaging structure and a manufacturing method thereof, which achieves the integration of multi-chip heterogeneous technology within the disclosed flip-chip bonding-based antenna packaging structure by combining a lead frame structure, which includes an RF chip, with a redistribution structure, which includes an antenna. In some embodiments, the flip-chip bonding-based antenna packaging structure disclosed herein may also exhibit the benefits of improved heat dissipation and a wider applicable bandwidth.

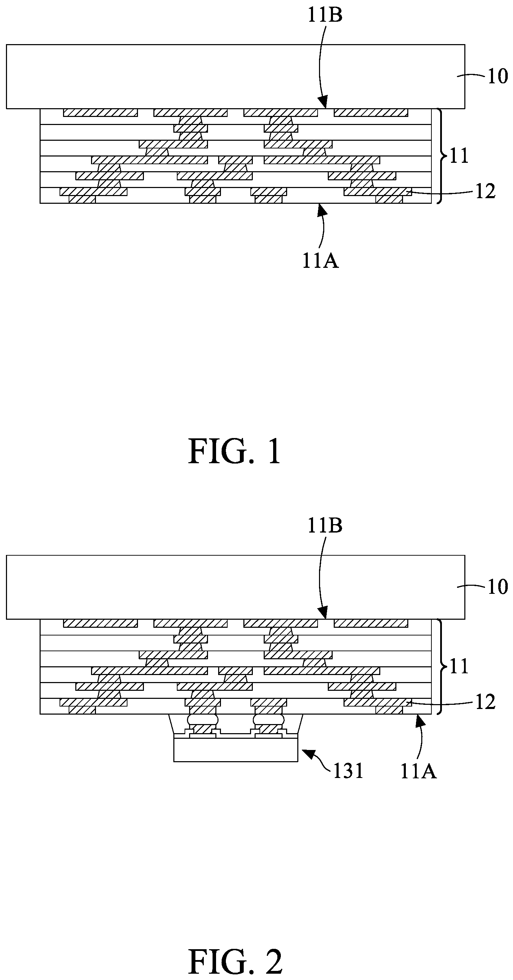

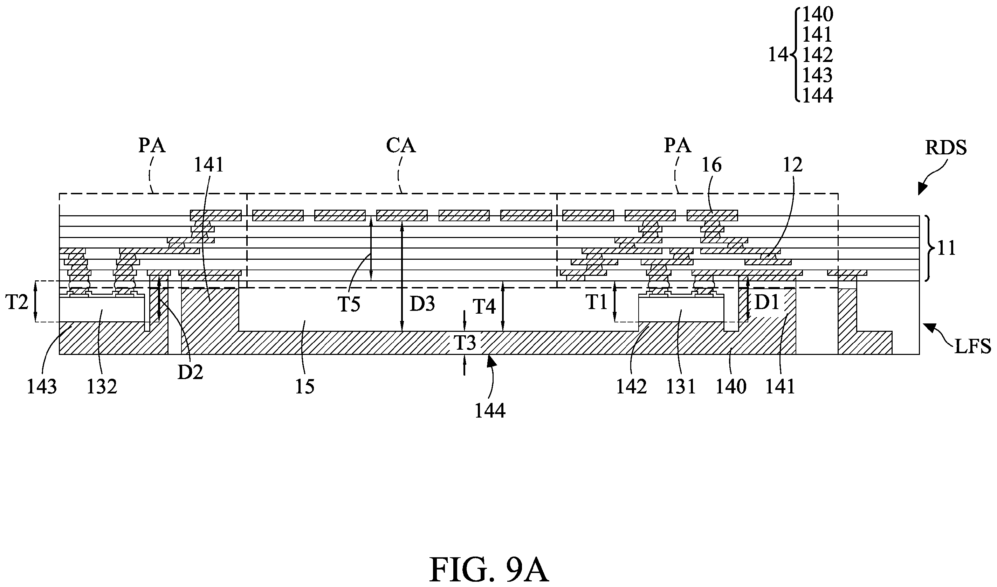

FIG. 1 to FIG. 6 are schematic cross-sectional views illustrating different stages of the manufacturing process for the flip-chip bonding-based antenna packaging structure in accordance with some embodiments of the present disclosure. It should be noted that, for the sake of simplicity, FIG. 1 to FIG. 6 only illustrate only a single active element for explanatory purposes. However, a person skilled in the art would understand that, multiple active elements (e.g., a first active element and a second active element) can be sequentially or simultaneously disposed in a flip-chip bonding-based antenna package structure using similar or identical processes. The multiple active elements may be similar or identical to each other and are positioned at corresponding locations. Therefore, a person skilled in the art can understand that a second active element (e.g., the second active element 132 in FIG. 9A) can be further provided on one side of the first active element (e.g., the first active element 131 in FIG. 9A) by employing steps that are similar or identical to those shown in FIG. 1 to FIG. 6, thereby achieving heterogeneous integration of multiple chips. Of course, the present disclosure is not limited thereto. In other embodiments, a person skilled in the art would further recognize that more active elements, such as three, four or more, may be sequentially or simultaneously disposed using steps that are similar or identical to those shown in FIG. 1 to FIG. 6.

As shown in FIG. 1, the manufacturing method for the flip-chip bonding-based antenna packaging structure includes: providing a carrier 10 for supporting a first dielectric layer 11 and an electrical connector 12 to be disposed thereon. In some embodiments, the carrier 10 may be or may include: a Group IV element or a Group IV compound, such as silicon (Si), diamond (C), or silicon carbide (SiC); a Group III-V compound, such as gallium nitride (GaN), aluminum gallium nitride (AlGaN), aluminum nitride (AlN), gallium phosphide (GaP), gallium arsenide (GaAs), or aluminum gallium arsenide (AlGaAs); other suitable materials; or a combination thereof. However, the present disclosure is not limited thereto. In some embodiments, the carrier 10 may be or may include glass, quartz, sapphire, ceramic, other suitable materials, or a combination thereof. However, the present disclosure is not limited thereto. In some embodiments, the carrier 10 may be or may include polyimide (PI), polycarbonate (PC), polyethylene terephthalate (PET), polypropylene (PP), other suitable materials, or a combination thereof. However, the present disclosure is not limited thereto. In some embodiments, the carrier 10 may be or may include a flexible substrate, a soft substrate, a rigid substrate, or a combination thereof. However, the present disclosure is not limited thereto.

Following the above step, a dielectric layer 11 is provided on the carrier 10, wherein the first dielectric layer 11 has a first surface 11A and a second surface 11B opposite to each other. For example, the first dielectric layer 11 may be disposed using a coating process, a curing process, a build-up process, other suitable methods, or a combination thereof. However, the present disclosure is not limited thereto. In some embodiments, the first dielectric layer 11 may be or may include thermal type or UV type polyimide (PI), colorless PI (CPI), photosensitive PI (PSPI), polybenzoxazole (PBO), liquid crystal polymer (LCP), other suitable materials, or a combination thereof. However, the present disclosure is not limited thereto. In some embodiments, the first dielectric layer 11 may have a single layer or a multi-layer structure.

Following the above steps, an electrical connector 12 is formed in the first dielectric layer 11. For example, the electrical connector 12 may be disposed using an electroplating process, a photolithography process, other suitable methods, or a combination thereof, depending on actual requirements. In some embodiments, the electrical connector 12 may be or may include an electrically conductive material. For example, the conductive material may include metal, metal compound, other suitable conductive materials, or a combination thereof. However, the present disclosure is not limited thereto. For example, the metal may be tin (Sn), copper (Cu), gold (Au), silver (Ag), nickel (Ni), indium (In), platinum (Pt), palladium (Pd), iridium (Ir), titanium (Ti), chromium (Cr), tungsten (W), aluminum (Al), molybdenum (Mo), titanium (Ti), magnesium (Mg), zinc (Zn), germanium (Ge), or an alloy thereof. For example, the metal compound may be tantalum nitride (TaN), titanium nitride (TiN), tungsten silicide (WSi 2), indium tin oxide (ITO), etc. In the embodiment where the first dielectric layer 11 has a multi-layer structure, the electrical connector 12 may include a vertical connector and a plurality of patterned circuit layers, and the vertical connector is used to connect the plurality of patterned circuit layers. In some embodiments, two ends of the electrical connector 12 are exposed through the first surface 11A and the second surface 11B of the first dielectric layer 11, respectively, to electrically connect active elements or passive elements to be disposed on the two surfaces of the first dielectric layer 11. The active element may be or may include a power chip, a low-noise filter chip, a switch element, other suitable chips, or a combination thereof, depending on actual requirements. The passive element may be a resistive element, a capacitive element, or may include an antenna.

As shown in FIG. 2, following the above steps, a first active element 131 and a second active element (not shown in FIG. 2, but refer to the second active element 132 in FIG. 9A) are disposed on the first surface 11A of the first dielectric layer 11, and the first active element 131 and the second active element (e.g., the second active element 132 in FIG. 9A) are electrically connected to the electrical connector 12. For example, the first active element 131 may be attached to the first surface 11A using a pad, a solder, or other suitable components, or a combination thereof. However, the present disclosure is not limited thereto.

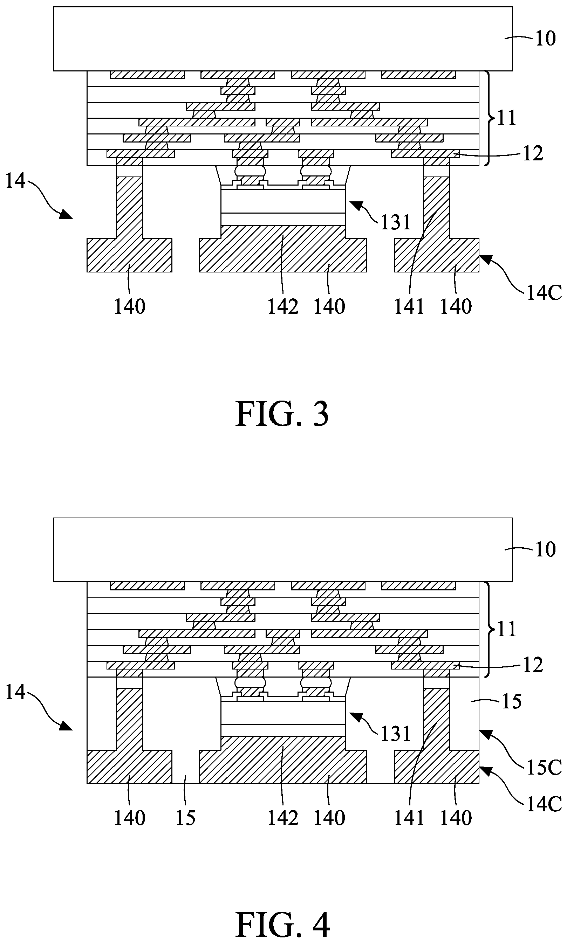

As shown in FIG. 3, following the above steps, a metal member 14 is disposed on the first active element 131 and the second active element (e.g., the second active element 132 in FIG. 9A), and the metal member 14 serves as a support structure (or lead frame) of the flip-chip bonding-based antenna packaging structure. For example, the metal member 14 may be attached to the first active element 131 using a pad, solder, other suitable components, or a combination thereof. After the metal member 14 is provided, the support of the entire flip-chip bonding-based antenna packaging structure is enhanced to prevent the flip-chip bonding-based antenna packaging structure from warping. In addition, the metal member 14, which is a good conductor of heat and electricity, may efficiently transfer the heat from the first active element 131 and the second active element to the outside, allowing the flip-chip bonding-based antenna packaging structure to maintain an appropriate operating temperature.

In some embodiments, the metal member 14 includes a base portion 140, an extension portion 141, a first supporting portion 142, and a second supporting portion (not shown in FIG. 3, but reference may be made to the second supporting portion 143 in FIG. 9A). Specifically, the base portion 140 extends along a horizontal direction (i.e., a direction parallel to the carrier 10) and supports the elements thereon (e.g., the extension portion 141, the first supporting portion 142, and the second supporting portion 143). In some embodiments, in a top view, the area of the base portion 140 may account for more than 50% of the area of the entire flip-chip bonding-based antenna packaging structure bonding-based antenna package structure. For example, the area of the base portion 140 may occupy 50% or any value or range between 50% and the aforementioned value of the entire flip-chip bonding-based antenna packaging structure. However, the present disclosure is not limited thereto. By increasing the area ratio of the base portion 140, the heat dissipation efficiency of the entire flip-chip bonding-based antenna packaging structure bonding-based antenna packaging structure may be improved.

The extension portion 141 is located on the base portion 140 and extends along a vertical direction (i.e., a direction perpendicular to the carrier 10), wherein the extension portion 141 is connected to the electrical connector 12, for example, electrically and physically. In some embodiments, the extension portion 141 may partially or entirely surround the side of the first active element 131 or the second active element (e.g., the second active element 132 in FIG. 9A) thereby shielding the active element and preventing it from being affected by surrounding signal interference. For example, the extension portion 141 may be located between the first active element 131 and the second active element (e.g., the second active element 132 in FIG. 9A) thereby preventing signal interference between the first active element 131 and the second active element (e.g., the second active element 132 in FIG. 9A) from interfering with each other. Furthermore, the extension portion 141 may be electrically connected to the passive element 16, which will be disposed later, through the electrical connector 12. It may also receive heat generated by the passive element 16 during operation, thereby enhancing the heat dissipation efficiency of the flip-chip bonding-based antenna packaging structure.

The first supporting portion 142 protrudes from the base portion 140 and is in direct contact with the first active element 131. Specifically, the first supporting portion 142 is located between the first active element 131 and the base portion 140. In other words, the height of the first supporting portion 142 may be adjusted to allow the metal member 14 to accommodate various active elements. For example, when the dimensions (e.g., thickness) of the first active element 131 is relatively large, the height of the first supporting portion 142 may be reduced so that the metal member 14 may be attached to the first active element 131 without applying excessive pressure on it. Conversely, when the dimensions (e.g., thickness) of the first active element 131 is relatively small, the height of the first supporting portion 142 may be increased so that the metal member 14 may support the first active element 131 and prevent separation from it. Similarly, the second supporting portion (refer to the second supporting portion 143 in FIG. 9A) protrudes from the base portion 140 and is in direct contact with the second active element (refer to the second active element 132 in FIG. 9A).

In some embodiments, various components of the metal member 14 (e.g., the base portion 140, the extension portion 141, the first supporting portion 142, and the second supporting portion 143) may be formed as an integral structure. In other words, the integrated metal member 14 may first be integrally formed, and then the metal member 14 may be bonded to the first active element 131 and the electrical connector 12. However, the present disclosure is not limited thereto. In other embodiments, the various components of the metal member 14 (e.g., the base portion 140, the extension portion 141, the first supporting portion 142, and the second supporting portion 143) may be individually disposed on the first active element 131 and the electrical connector 12 in sequence, and then the various components of the metal member 14 may be connected together by welding, bonding, other suitable methods, or a combination thereof.

As shown in FIG. 4, following the above steps, after the metal member 14 has been disposed, a second dielectric layer 15 is further filled between the metal member 14 and the first dielectric layer 11. It should be noted that, hereinafter, the active elements (e.g., the first active element 131 and the second active element 132), the metal member 14, and the second dielectric layer 15 will collectively be referred to as the lead frame structure (LFS).

In some embodiments, the second dielectric layer 15 may be or may include thermosetting or UV-curable polyimide (PI), transparent polyimide (CPI), photosensitive polyimide (PSPI), polybenzoxazole (PBO), liquid crystal polymer (LCP), other suitable materials, or a combination thereof. However, the present disclosure is not limited thereto. In some embodiments, the material of the second dielectric layer 15 may be similar to or the same as the material of the first dielectric layer 11. However, the present disclosure is not limited thereto.

In some embodiments, the base portion 140 of the metal member 14 may be exposed through the bottom surface 15B of the second dielectric layer 15. Furthermore, the base portion 140 of the metal member 14 may be coplanar with the bottom surface 15B of the second dielectric layer 15. In this case, the exposed base portion 140 may facilitate heat exchange with the external environment (e.g., by heat radiation or heat convection) to enhance heat dissipation efficiency. In some cases, the exposed base portion 140 may also function as a contact (or pin) for electrical connection with other components.

In some embodiments, the sidewall 14C of the metal member 14 may be exposed through the sidewall 15C of the second dielectric layer 15. Furthermore, the sidewall 14C of the metal member 14 may be coplanar with the sidewall 15C of the second dielectric layer 15. In this case, the sidewall 14C of the metal member 14 may function as a contact (or pin) for electrical connection with other components. In other words, the metal member 14 of the present disclosure may be electrically connected to other components via either of the two surfaces (the bottom surface and the side surface), thereby facilitating improved design flexibility.

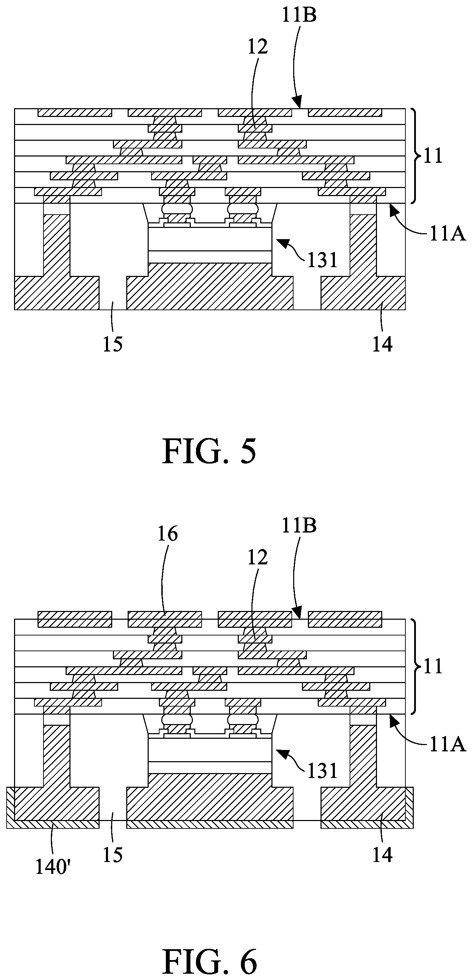

As shown in FIG. 5, following the above steps, the carrier 10 is removed to expose the second surface 11B of the first dielectric layer 11 and the electrical connector 12. For example, the carrier 10 may be removed by physical destruction, an etching process, other suitable processes, or a combination thereof. However, the present disclosure is not limited thereto. In some embodiments, after the carrier 10 is removed, a cleaning process, such as chemical mechanical polishing, may be performed to clean the exposed first dielectric layer 11 and the electrical connector 12.

As shown in FIG. 6, following the above steps, a passive element 16 is disposed on the electrical connector 12, wherein the passive element 16 is electrically connected to the electrical connector 12. It should be noted that, hereinafter, the passive element 16, the first dielectric layer 11, and the electrical connector 12 will collectively be referred to as the redistribution structure RDS. In this case, a patterned metal layer may be formed on the second surface 11B of the first dielectric layer 11 using electroless nickel immersion gold (ENIG), electroless nickel palladium immersion gold (ENEPIG), electroplating processes, patterning processes, other similar processes, or a combination thereof, and used to prevent oxidation of the passive element 16.

Optionally, in some embodiments, a patterned metal layer 140' may additionally be formed on the coplanar surface of the metal member 14 and the second dielectric layer 15 by electroless nickel immersion gold plating, electroless nickel palladium immersion gold plating, electroplating processes, patterning processes, other similar processes, or a combination thereof, and used to prevent oxidation of the metal member 14. In some embodiments, the step of forming a patterned metal layer on the second surface 11B of the first dielectric layer 11 and the step of forming a patterned metal layer 140' on the coplanar surface of the metal member 14 and the second dielectric layer 15 may be performed using the same process or different processes. However, the present disclosure is not limited thereto. In some embodiments, the material of the patterned metal layer 140' may be the same as or different from the material of the base portion 140 of the metal member 14.

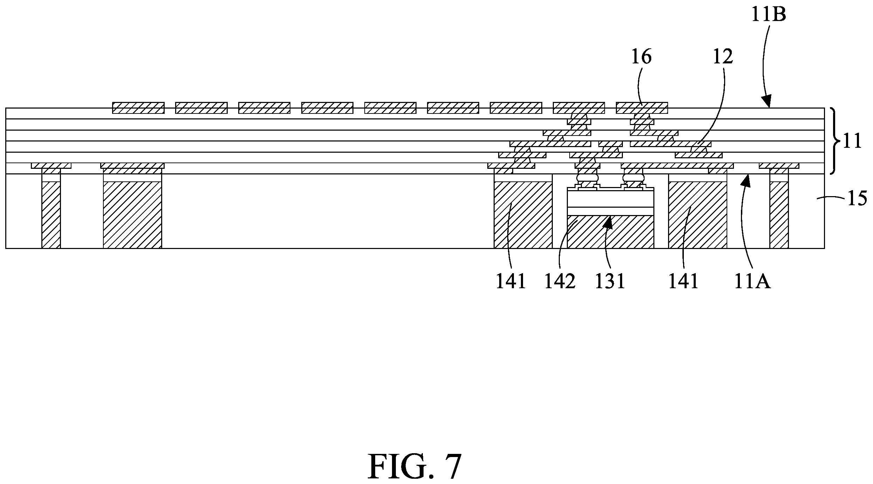

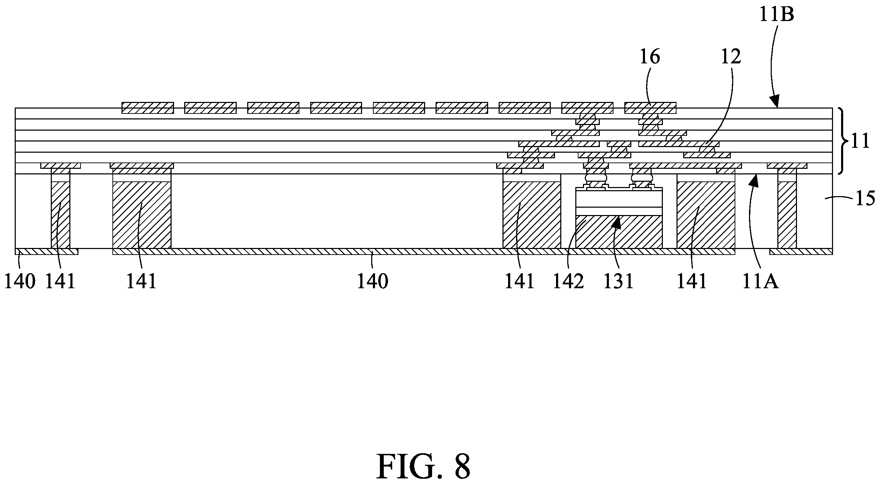

It should be noted that the above steps are only examples and the present disclosure is not limited thereto. For example, some of the above steps may be replaced by the steps of FIG. 7 and FIG. 8. FIG. 7 and FIG. 8 are schematic cross-sectional views showing different stages of a manufacturing method for the flip-chip bonding-based antenna packaging structure according to other embodiments of the present disclosure.

As shown in FIG. 7, following the step of FIG. 2, after the first active element 131 and the second active element (e.g., the second active element 132 in FIG. 9A) are disposed, the extension portion 141, the first supporting portion 142 and the second supporting portion (not shown in FIG. 7, but reference may be made to the second supporting portion 143 in FIG. 9A) of the metal member 14 are disposed on the first active element 131 and the second active element (not shown), while the base portion 140 is not yet disposed. In other words, in these embodiments, the components of the metal member 14 (e.g., the base portion 140, the extension portion 141, the first supporting portion 142, and the second supporting portion 143) are not formed as an integral structure. The extension portion 141, the first supporting portion 142, and the second supporting portion 143 are disposed in this step, and the base portion 140 is disposed in a subsequent step.

Following the above steps, after the extension portion 141, the first supporting portion 142, and the second supporting portion (not shown) are disposed, the second dielectric layer 15 is further filled between the metal member 14 and the first dielectric layer 11. Following the above steps, the passive element 16 is disposed on the electrical connector 12. For example, the second dielectric layer 15 may be filled around the first supporting portion 142, the second supporting portion (not shown), and the extension portion 141 to make the second dielectric layer 15 coplanar with the first supporting portion 142, the second supporting portion (not shown), and the extension portion 141.

As shown in FIG. 8, following the above steps, the base portion 140 is disposed on the second dielectric layer 15, the extension portion 141, the first supporting portion 142, and the second supporting portion (not shown). For example, the base portion 140 may be formed by a plating process, such as sputtering or evaporation. The metal member 14 disposed in the above manner may have at least the following benefits. For example, this approach may improve the problem of poor interface bonding between the second dielectric layer 15 and the metal member 14. Alternatively, since the base portion 140 formed by the plating process is usually thinner (e.g., less than <20 μm), this approach may also reduce the warpage between components due to stress mismatch by using the thinner base portion 140. Of course, the present disclosure may also adopt other methods to sequentially or independently form the components of the metal member 14 to meet different product requirements.

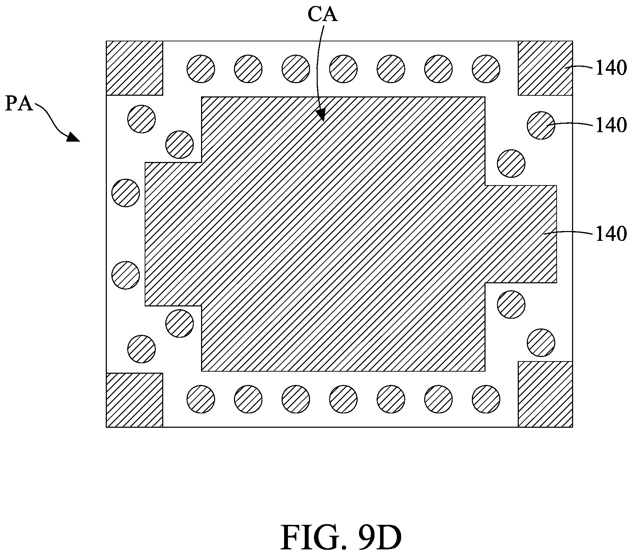

After the above steps, a flip-chip bonding-based antenna packaging structure may be obtained. FIG. 9A and FIG. 9D are respectively a cross-sectional schematic diagram and a top schematic diagram illustrating the flip-chip bonding-based antenna packaging structure according to some embodiments of the present disclosure. As shown in the figure, the flip-chip bonding-based antenna packaging structure includes the lead frame structure LFS and the redistribution structure RDS. The lead frame structure LFS includes the metal member 14, the first active element 131, the second active element 132, and the second dielectric layer 15. The metal member 14 includes the base portion 140, the extension portion 141, the first supporting portion 142, and the second supporting portion 143. The first active element 131 is disposed on the first supporting portion 142. The second active element 132 is disposed on the second supporting portion 143. The second active element 132 is located at one side of the first active element 131, and these two may be separated by the extension portion 141 of the metal member 14. The second dielectric layer 15 is filled between the metal member 14 and the redistribution structure RDS.

The redistribution structure RDS is disposed on the lead frame structure LFS and includes the first dielectric layer 11, the electrical connector 12, and the passive element 16. The first dielectric layer 11 is disposed on the first active device 131 and the second active device 132. The electrical connector 12 is disposed in the first dielectric layer 11 and electrically connects the first active element 131 and the second active element 132. The passive element 16 is disposed on the first dielectric layer 11, and is electrically connected to the first active element 131 and the second active element 132 through the electrical connector 12.

In this embodiment, the dimensions of the first active element 131 are the same as the dimensions of the second active element 132. For example, the first active element 131 may have a first thickness T1, the second active element 132 may have a second thickness T2, and the first thickness T1 is the same as the second thickness T2. In this case, the distance D1 (corresponding to the first thickness T1) between the first supporting portion 142 and the first dielectric layer 11 is the same as the distance D2 (corresponding to the second thickness T2) between the second supporting portion 143 and the first dielectric layer 11.

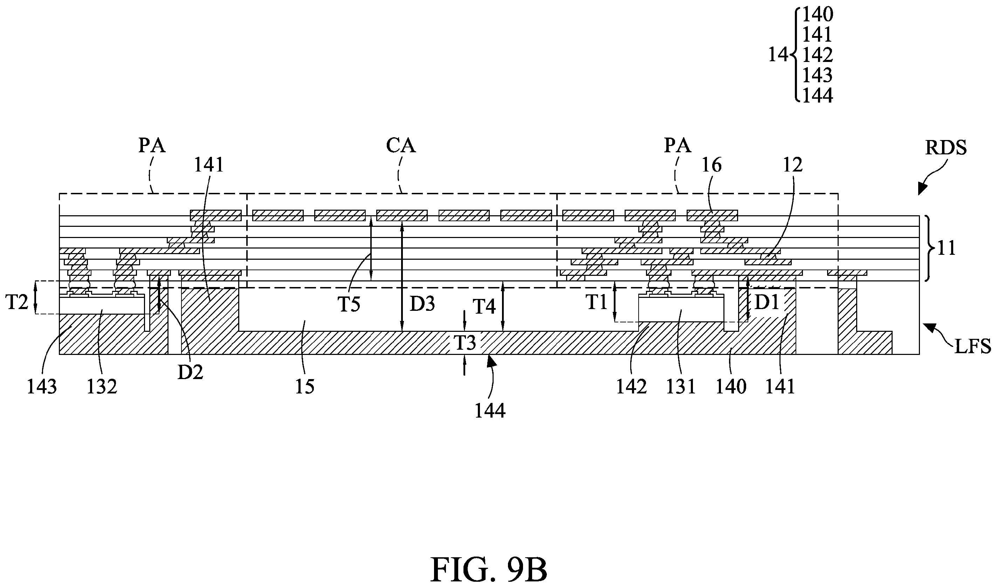

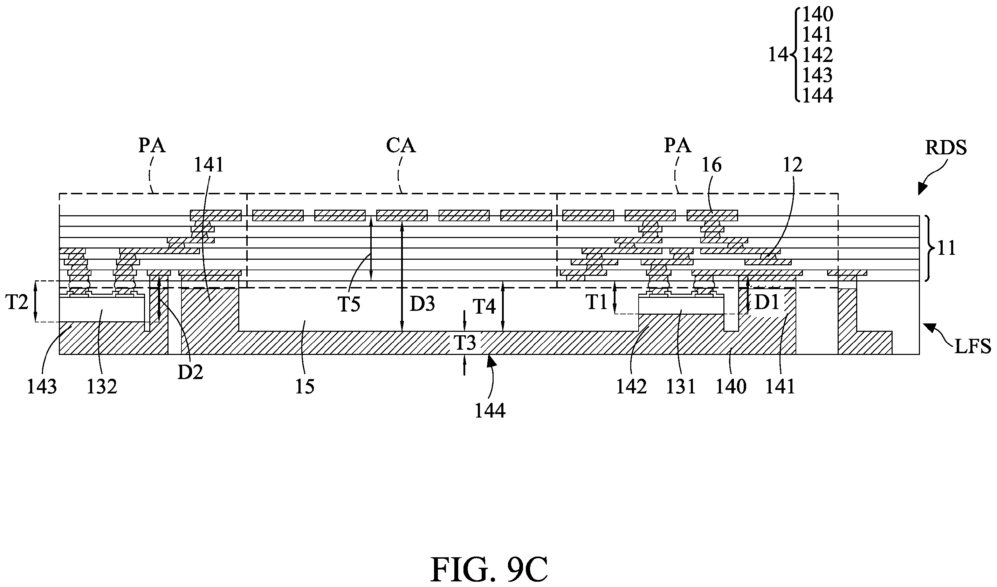

However, the present disclosure is not limited thereto. Since the first supporting portion 142 and the second supporting portion 143 of the metal member 14 may be adjusted according to design requirements, the flip-chip bonding-based antenna packaging structure disclosed in the present disclosure may be applicable to heterogeneous chips of different sizes. For example, referring to FIG. 9B and FIG. 9C, which are schematic cross-sectional diagrams illustrating the flip-chip bonding-based antenna packaging structure bonding according to other embodiments and yet other embodiments of the present disclosure, respectively. As shown in FIG. 9B, in this embodiment, the first thickness T1 of the first active element 131 is greater than the second thickness T2 of the second active element 132. In this case, the distance D1 between the first supporting portion 142 and the first dielectric layer 11 is greater than the distance D2 between the second supporting portion 143 and the first dielectric layer 11. As shown in FIG. 9C, in this embodiment, the first thickness T1 of the first active element 131 is smaller than the second thickness T2 of the second active element 132. In this case, the distance D1 between the first supporting portion 142 and the first dielectric layer 11 is smaller than the distance D2 between the second supporting portion 143 and the first dielectric layer 11. In other words, the present disclosure may achieve multi-chip heterogeneous integration in the flip-chip bonding-based antenna packaging structure by adjusting the dimensions of the metal member 14.

In some embodiments, in addition to thickness, the first active element 131 and the second active element 132 may also have different widths, lengths or shapes. Alternatively, the first active element 131 and the second active element 132 may also include different chips to achieve different functions. For example, the first active element 131 may be a radio frequency chip corresponding to a first frequency band, and the second active element 132 may be a radio frequency chip corresponding to a second frequency band, and the first frequency band is different from the second frequency band.

In some embodiments, the first dielectric layer 11 has a central area CA and a peripheral area PA surrounding the central area CA. The passive element 16 (e.g., antenna) is disposed in the central area CA. The first active device 131 and the second active device 132 are disposed below the peripheral area PA. The metal member 14 further includes a grounding portion 144 located below the central area CA. As the bandwidth of the antenna increases, the thickness of the dielectric material (i.e., the first dielectric layer 11 and the second dielectric layer 15) between the antenna and the ground portion 144 needs to be increased. Therefore, the distance between the passive element 16 and the metal member 14 is increased by adjusting the height of the extension portion 141. For example, in the central area CA, the distance D3 between the passive element 16 and the metal member 14 may be at least 200 $\mu$m, such as 201 $\mu$m, 300 $\mu$m, 400 $\mu$m, 500 $\mu$m, 600 $\mu$m, 700 $\mu$m, 1000 $\mu$m, or any value or range therebetween.

In some embodiments, no metal or chip is disposed within the dielectric material (i.e., the first dielectric layer 11 and the second dielectric layer 15) between the passive element 16 in the central area CA and the grounding portion 144 located thereunder. Specifically, no active elements (such as chips), circuit layers, electrical connectors, or other conductive materials are present in the first dielectric layer 11 or the second dielectric layer 15. This configuration may effectively reduce electromagnetic interference (EMI) and signal crosstalk, thereby improving the stability and integrity of RF signals and preventing issues such as signal distortion, reflection, or delay caused by the presence of metal or chips. Furthermore, by filling additional dielectric materials between the dielectric layers, the applicable bandwidth range of the flip-chip bonding-based antenna packaging structure may be effectively expanded.

In some applications of the present disclosure, the operating bandwidth (BW) of the flip-chip bonding-based antenna packaging structure bonding antenna package structure, the total thickness of the dielectric material (i.e., the first dielectric layer 11 and the second dielectric layer 15), and the dielectric constant (Dk, $\varepsilon r$) exhibit a relationship. For example, when the material of the first dielectric layer 11 is different from the material of the second dielectric layer 15, or the interface between the first dielectric layer 11 and the second dielectric layer 15 is not perfectly matched, the relationship may be as shown in Equation 1 below. In this equation, BW denotes the operating bandwidth, h1 denotes the thickness of the first dielectric layer 11, $\varepsilon 1$ denotes the dielectric constant (Dk, $\varepsilon r$) of the first dielectric layer 11, h2 denotes the thickness of the second dielectric layer 15, and $\varepsilon 2$ denotes the dielectric constant (Dk, $\varepsilon r$) of the second dielectric layer 15.

Equation 1 is showing as follows.

$$BW \propto \frac{1}{\sqrt{\left(\frac{(h1\varepsilon1 + h2\varepsilon2)}{(h1 + h2)}\right) \quad (h1 + h2)}}$$

In some embodiments, the dielectric constant (Dk) of the first dielectric layer 11 and/or the second dielectric layer 15 may be less than 4.0, and the dissipation factor (Df) of the first dielectric layer 11 and/or the second dielectric layer 15 may be less than 0.004. In some embodiments, with consideration of radiation attenuation, the total thickness of the dielectric material (i.e., the first dielectric layer 11 and the second dielectric layer 15) is preferably as large as possible.

In some applications of the present disclosure, the total thickness of the flip-chip bonding-based antenna packaging structure may range from 180 $\mu$m to 270 $\mu$m. As shown in FIG. 9A, for example, the base portion 140 of the metal member 14 has a third thickness T3, and the third thickness T3 may range from 70 $\mu$m to 130 $\mu$m. The second dielectric layer 15 has a fourth thickness T4, and the fourth thickness T4 may range from 170 $\mu$m to 230 $\mu$m. The first dielectric layer 11 has a fifth thickness T5, and the fifth thickness T5 may range from 10 $\mu$m to 40 $\mu$m. Generally speaking, a thickness ratio (T5: T4) between the first dielectric layer 11 and the second dielectric layer 15 may range from 1:18 to 1:6, and/or a thickness ratio (T3: T4) between the base portion 140 and the second dielectric layer 15 may range from 1:2 to 1:1.5. By configuring the flip-chip bonding-based antenna packaging structure to have the above-mentioned thicknesses and ratios, warpage can be effectively mitigated. It should be noted that the above specific numerical values are provided for illustrative purposes only, and the present disclosure is not limited thereto.

In some applications of the present disclosure, the operating bandwidth (BW) of the flip-chip bonding-based antenna packaging structure may be 60 GHz. In this case, the total thickness of the dielectric material (i.e., the first dielectric layer 11 and the second dielectric layer 15) may be in the range of 1% to 5% of the standard wavelength of 5 mm, i.e., between 0.05 mm and 0.25 mm. In other applications of the present disclosure, the operating bandwidth (BW) may be 70 GHz. In this case, the total thickness of the dielectric material may be in the range of 1% to 5% of the standard wavelength of 4.29 mm, i.e., between 0.043 mm and 0.215 mm. In some other applications of the present disclosure, the operating bandwidth (BW) may be as high as 100 GHz. In this case, the total thickness of the dielectric material may be in the range of 1% to 5% of the standard wavelength of 3 mm, i.e., between 0.03 mm and 0.15 mm. In other words, even when the operating bandwidth (BW) reaches 100 GHz, the present disclosure can still accommodate various chips as long as the thickness of these chips is still less than 0.15 mm. For example, in some applications of the present disclosure, the thickness of the first active element 131 and/or the second active element 132 may range from 80 $\mu$m to 120 $\mu$m, such as 100 $\mu$m. However, the present disclosure is not limited thereto.

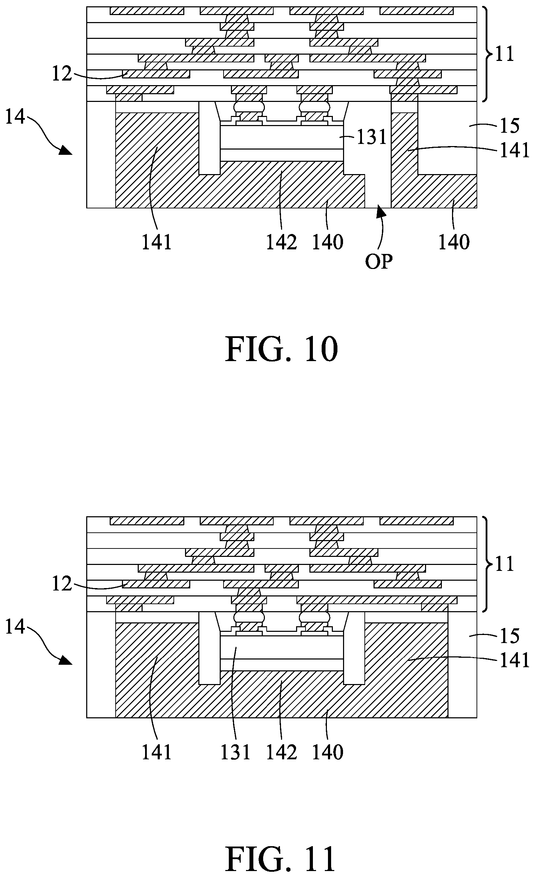

As described above, the flip-chip bonding-based antenna packaging structure and its manufacturing method have been generally disclosed according to some embodiments of the present disclosure. However, the present disclosure is not limited thereto. In other embodiments, the shape or dimensions of the metal member 14 may be adjusted to enhance specific functions of the flip-chip bonding-based antenna packaging structure, thereby providing greater design flexibility. For further illustration, reference may be made to FIG. 10 to FIG. 14, which are schematic cross-sectional diagrams illustrating different aspects of the flip-chip bonding-based antenna packaging structure according to some embodiments of the present disclosure.

As shown in FIG. 10, a flip-chip bonding-based antenna packaging structure is illustrated. The difference from the embodiment of FIG. 6 is that the extension portion 141 of the metal member 14 and the base portion 140 may collectively form an "L-shaped structure". More specifically, in this embodiment, the extension portion 141 located on one side (left side) of the first active element 131 and the base portion 140 located below the first active element 131 are connected together to form the aforementioned "L-shaped structure". In addition, the extension portion 141 located on the other side (right side) of the first active element 131 and the base portion 140 located below the first active element 131 are not connected together, and together form an opening OP.

As shown in FIG. 11, a flip-chip bonding-based antenna packaging structure is illustrated. The difference from the embodiment of FIG. 6 is that the extension portion 141 of the metal member 14 and the base portion 140 may collectively form a "U-shaped structure". More specifically, in this embodiment, the extension portions 141 located on both sides of the first active element 131 are connected to the base portion 140 located below the first active element 131, thereby forming the aforementioned "U-shaped structure".

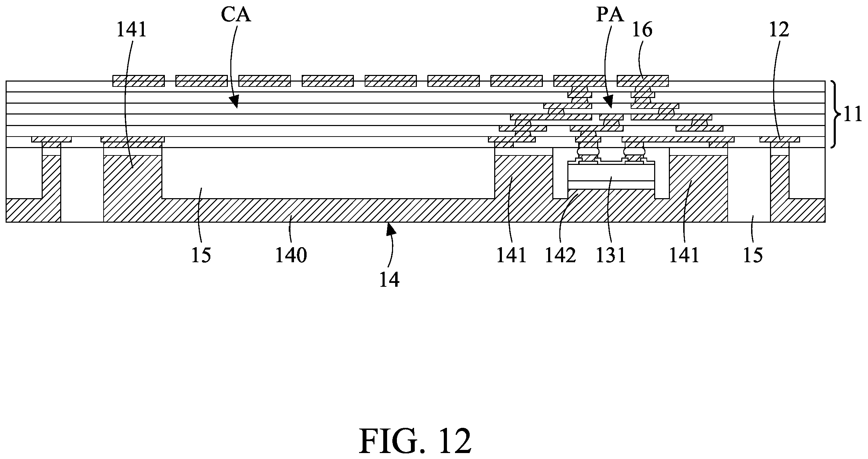

As shown in FIG. 12, a flip-chip bonding-based antenna packaging structure is illustrated. In this embodiment, the extension portion 141 surrounds the first active device 131 in the peripheral area PA, and the extension portion 141 surrounds the second dielectric layer 15 in the central area CA. In addition, in this embodiment, the base portion 140 of the metal member 14 continuously extends from below the central area CA of the first dielectric layer 11 to below the peripheral area PA of the first dielectric layer 11. In this way, it is possible to prevent external signals from interfering with the first active device 131 and helps maintain the electrical characteristics of the central area CA of the flip-chip bonding-based antenna packaging structure.

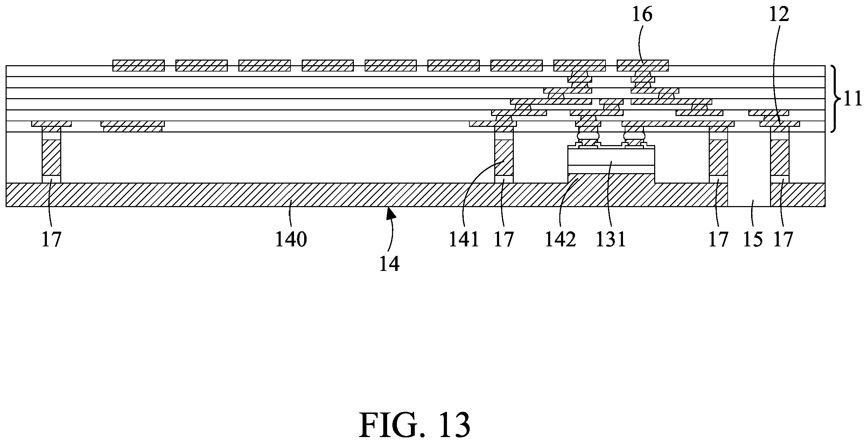

As shown in FIG. 13, a flip-chip bonding-based antenna packaging structure is illustrated. The difference from the embodiment of FIG. 12 is that the metal member 14 is not formed in one piece. More specifically, the base portion 140 and the extension portion 141 of the metal member 14 are two separate components and are joined together through welding, bonding (e.g., adhesive 17), other appropriate methods, or a combination thereof. In this case, the design flexibility of the flip-chip bonding-based antenna packaging structure may be improved.

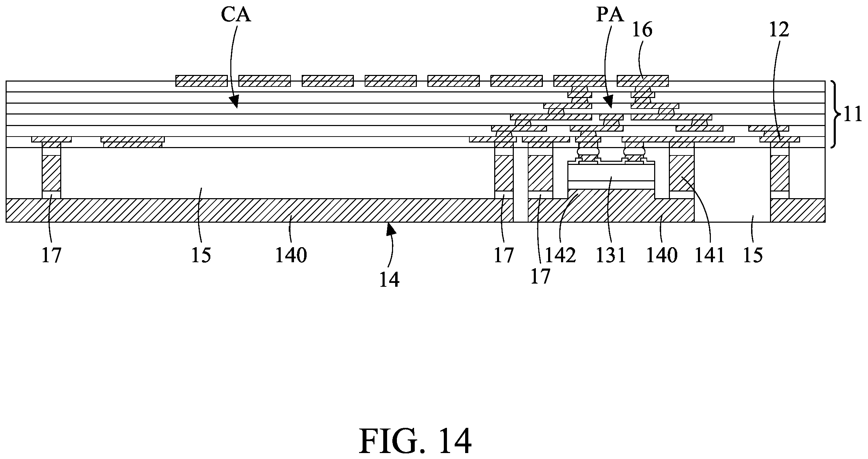

As shown in FIG. 14, a flip-chip bonding-based antenna packaging structure is illustrated. The difference from the embodiment of FIG. 13 is that the extension portion 141 of the metal member 14 and the base portion 140 may collectively form a "U-shaped structure", and the base portion 140 of the metal member 14 does not extend continuously from below the central area CA of the first dielectric layer 11 to below the peripheral area PA of the first dielectric layer 11. In this case, the design flexibility of the flip-chip bonding-based antenna packaging structure may be improved.

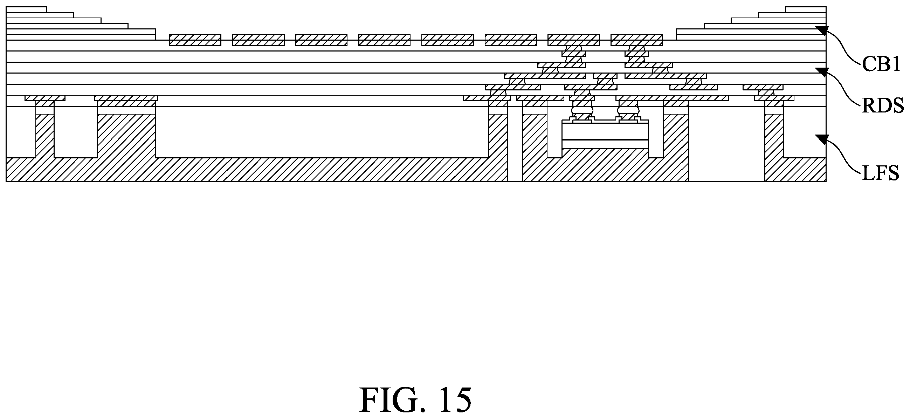

In addition to the above aspects, in other embodiments, other elements may be further disposed on the lead frame structure LFS and the redistribution structure RDS. For further illustration, reference may be made to FIG. 15 to FIG. 18, which are schematic cross-sectional diagrams illustrating different aspects of the flip-chip bonding-based antenna packaging structure bonding according to some embodiments of the present disclosure.

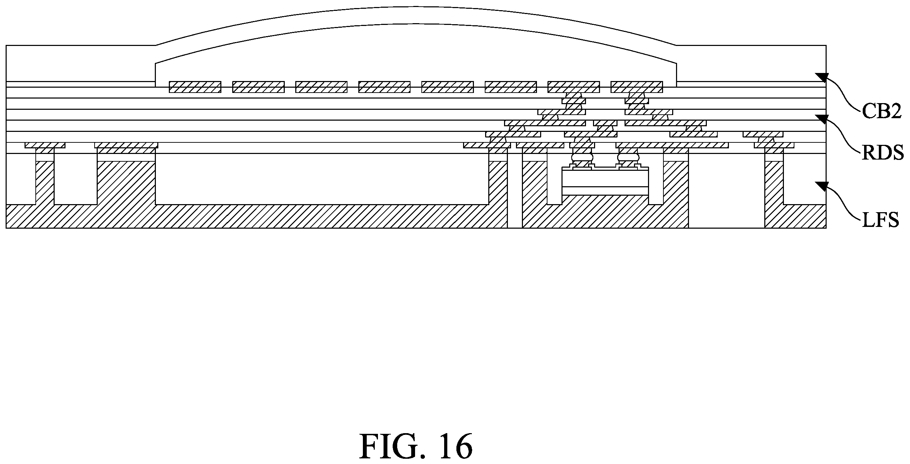

As shown in FIG. 15, in some embodiments, a circuit board CB1 such as a low temperature co-fired ceramic substrate (LTCC) or a high density interconnect substrate (HDI) may be further disposed on the redistribution structure RDS to enhance the device performance of the flip-chip bonding-based antenna packaging structure. Alternatively, as shown in FIG. 16, in some embodiments, a circuit board CB2 including plastic may be further disposed on the redistribution structure RDS to enhance the device performance of the flip-chip bonding-based antenna packaging structure.

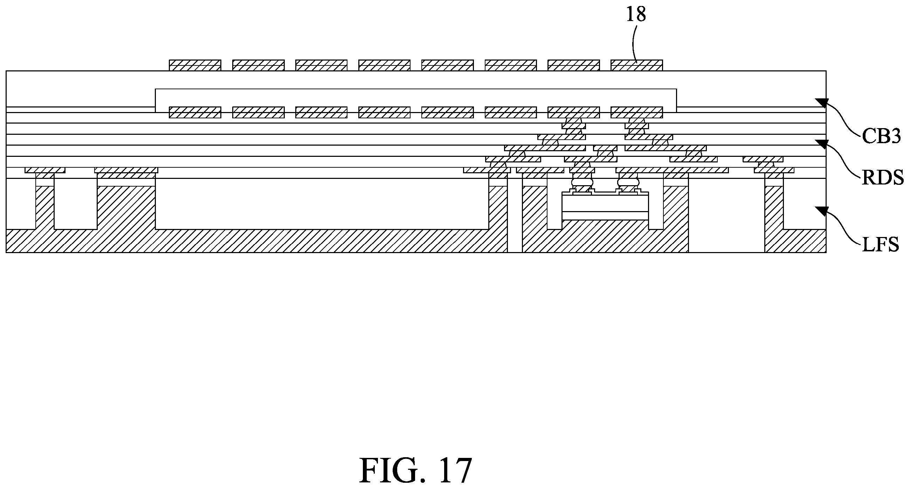

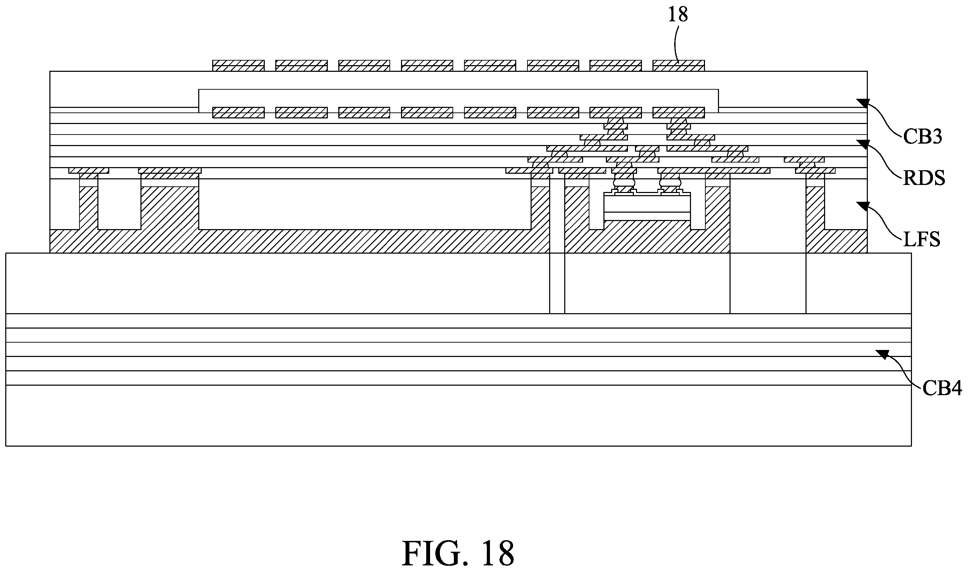

As shown in FIG. 17, in some embodiments, a circuit board CB3 such as a low temperature co-fired ceramic substrate (LTCC) or a high density interconnect substrate (HDI) may be further disposed on the redistribution structure RDS, and other passive elements 18 (e.g., antennas) may be disposed on these substrates to enhance the device performance of the flip-chip bonding-based antenna packaging structure. Alternatively, as shown in FIG. 18, in some embodiments, in addition to the circuit board CB3 and the passive element 18 such as a low temperature co-fired ceramic substrate (LTCC) or a high density interconnect substrate (HDI) disposed on the redistribution structure RDS, a circuit board CB4 such as a printed circuit board (PCB) may also be disposed beneath the lead frame structure LFS. In other words, the flip-chip bonding-based antenna packaging structure disclosed herein may also significantly improve applicability and design flexibility by simply combining the redistribution structure RDS, the lead frame structure LFS, and other structures, thereby solving some problems in the prior art.

In summary, the present disclosure provides the flip-chip bonding-based antenna packaging structure and its manufacturing method. By integrating the lead frame structure with the redistribution structure, this design not only enables the packaging of heterogeneous chips but also offers enhanced heat dissipation and a higher applicable bandwidth.

The components of the disclosed embodiments may be freely combined and utilized as long as they do not violate the spirit of the invention or conflict with each other. Furthermore, the scope of protection of the present disclosure is not limited to the processes, machines, manufacturing methods, material compositions, devices, methods, and steps described in the specific embodiments set forth in the specification. Any person of ordinary skill in the art may recognize, based on the teachings of the present disclosure, that existing or future-developed processes, machines, manufacturing methods, material compositions, devices, methods, and steps that achieve substantially the same function or yield substantially the same result as those described herein may be applied under the present disclosure. Accordingly, the scope of the present disclosure encompasses the aforementioned processes, machines, manufacturing methods, material compositions, devices, methods, and steps. Moreover, no particular embodiment or claim of the present disclosure is required to achieve all the objectives, advantages, and/or features disclosed herein.

The foregoing outlines features of several embodiments so that a person having ordinary skill in the art may better understand the aspects of the present disclosure. A person having ordinary skill in the art should appreciate that they may readily use the present disclosure as a basis for designing or modifying other processes and structures for carrying out the same purposes and/or achieving the same advantages of the embodiments introduced herein. A person having ordinary skill in the art should also realize that such equivalent constructions do not depart from the spirit and scope of the present disclosure, and that they may make various changes, substitutions, and alterations herein without departing from the spirit and scope of the present disclosure.

## Claims

1. A flip-chip bonding-based antenna packaging structure, comprising:

   a redistribution structure (RDS) comprising a first surface (11A) and a second surface (11B) opposite to each other; and
   a lead frame structure (LFS) disposed on the redistribution structure (RDS), comprising:

   a metal member (14) comprising a base portion (140), a first supporting portion (142) extending along a vertical direction on the base portion (140), and an extension portion (141) adjacent to the first supporting portion (142), wherein the extension portion (141) extends from the base portion (140) to be attached to the first surface (11A), and the first supporting portion (142) is parallel to the extension portion (141);
   a first active element (131) disposed between the first supporting portion (142) and the first surface (11A) and attached to the first surface (11A); and
   a passive element (16) disposed on the second surface (11B) and electrically connected to the first active element (131).

2. The flip-chip bonding-based antenna packaging structure as claimed in claim 1, wherein the metal member (14) further has a second supporting portion (143), the second supporting portion (143) is parallel to the extension portion (141); and the lead frame structure (LFS) further has a second active element (132), the second active element (132) is disposed between the second supporting portion (143) and the first surface (11A) and is attached to the first surface (11A).

3. The flip-chip bonding-based antenna packaging structure as claimed in claim 2, wherein a distance between the first supporting portion (142) and the first surface (11A) is different from a distance between the second supporting portion (143) and the first surface (11A).

4. The flip-chip bonding-based antenna packaging structure as claimed in claim 2, wherein the redistribution structure (RDS) has a central area (CA) and a peripheral area (PA) surrounding the central area (CA), the passive element (16) is disposed in the central area (CA), and the first active element (131) and the second active element (132) are disposed below the peripheral area (PA).

5. The flip-chip bonding-based antenna packaging structure as claimed in claim 2, wherein the extension portion (141) is located between the first active element (131) and the second active element (132).

6. The flip-chip bonding-based antenna packaging structure as claimed in any one of claims 1-5, wherein the lead frame structure (LFS) further comprises a dielectric layer (15) disposed around the base portion (140), the first supporting portion (142), and the extension portion (141), and the dielectric layer (15) and the extension portion (141) are coplanar.

7. The flip-chip bonding-based antenna packaging structure as claimed in claim 6, wherein the redistribution structure (RDS) further comprises a side wall that is a coplanar surface formed by a side wall (14C) of the metal member (14) and a side wall (15C) of the dielectric layer (15).

8. The flip-chip bonding-based antenna packaging structure as claimed in any one of claims 1-7, wherein, in a region extending from the base portion (140) to the second surface (11B), on one side of the extension portion (141) or the first active element (131), no passive element (16) or first active element (131) is disposed.

9. The flip-chip bonding-based antenna packaging structure as claimed in any one of claims 1-8, wherein the metal member (14) further comprises a patterned metal layer (140'), and the patterned metal layer (140') covers an outer surface of the base portion (140).

10. A manufacturing method for a flip-chip bonding-based antenna packaging structure, comprising:

   providing a redistribution structure (RDS) on a carrier (10), wherein the redistribution structure (RDS) has a first surface (11A) and a second surface (11B) opposite to each other;
   disposing a first active element (131) on the first surface (11A);
   disposing a metal member (14) on the first active element (131), wherein the metal member (14) comprises a base portion (140), a first supporting portion (142) extending along a vertical direction on the base portion (140), and an extension portion (141) adjacent to the first supporting portion (142), wherein the extension portion (141) extends from the base portion (140) to be attached to the first surface (11A), the first supporting portion (142) is parallel to the extension portion (141), and the first active element (131) is disposed between the first surface (11A) and the first supporting portion (142);
   removing the carrier (10) to expose the second surface (11B); and
   disposing a passive element (16) on the second surface (11B) to be electrically connected to the first active element (131).

11. The manufacturing method for the flip-chip bonding-based antenna packaging structure as claimed in claim 10, wherein the metal member (14) further comprises a second supporting portion (143), the second supporting portion (143) is parallel to the extension portion (141), and the manufacturing method further comprises:
   after disposing the first active element (131) on the first surface (11A), disposing a second active element (132) between the first surface (11A) and the second supporting portion (143), wherein the second active element (132) is electrically connected to the passive element (16).

12. The manufacturing method for the flip-chip bonding-based antenna packaging structure as claimed in claim 11, wherein the redistribution structure (RDS) has a central area (CA) and a peripheral area (PA) surrounding the central area (CA), the passive element (16) is disposed in the central area (CA), and the first active element (131) and the second active element (132) are disposed below the peripheral area (PA).

13. The manufacturing method for the flip-chip bonding-based antenna packaging structure as claimed in any one of claims 10-12, further comprising:
   after disposing the metal member (14), further filling a second dielectric layer (15) around the base portion (140), the first supporting portion (142), and the extension portion (141), wherein the second dielectric layer (15) and the base portion (140) are coplanar.

14. The manufacturing method for the flip-chip bonding-based antenna packaging structure as claimed in any one of claims 10-13, wherein disposing the metal member (14) comprises:

disposing the extension portion (141) and the first supporting portion (142) above the first active element (131);
filling a second dielectric layer (15) around the first supporting portion (142) and the extension portion (141), wherein the second dielectric layer (15), the first supporting portion (142), and the extension portion (141) are coplanar; and
disposing the base portion (140) on the second dielectric layer (15), the extension portion (141), and the first supporting portion (142).

15. The manufacturing method for the flip-chip bonding-based antenna packaging structure as claimed in claim 10, wherein no passive element or first active element is disposed, in a region extending from the base portion to the second surface, on one side of the extension portion or the first active element.

FIG. 1

FIG. 2

FIG. 3

FIG. 4

**FIG. 5**

**FIG. 6**

FIG. 7

EP 4 700 831 A2

FIG. 8

FIG. 9A

FIG. 9B

EP 4 700 831 A2

FIG. 9C

EP 4 700 831 A2

FIG. 9D

EP 4 700 831 A2

FIG. 10

FIG. 11

FIG. 12

EP 4 700 831 A2

FIG. 13

FIG. 14

CA    PA    16    12

11

17    15    140    17    142    131    140    141    15

14

17

EP 4 700 831 A2

FIG. 15

CB1

RDS

LFS

EP 4 700 831 A2

FIG. 16

**FIG. 17**

EP 4 700 831 A2

FIG. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63684603
- TW 114104780